# EUROPEAN PATENT APPLICATION

(11) **EP 4 542 656 A1**
(43) Date of publication of application: **23.04.2025**
(21) Application number: 23823828.1
(22) Date of filing: 08.06.2023
(51) Int. Cl.: H01L 29/872, H01L 21/329, H01L 29/06, H01L 29/861, H01L 29/866, H01L 29/868

(54) **SEMICONDUCTOR DEVICE**

(30) Priority: 17.06.2022 JP 2022097839
(71) Applicant: Shindengen Electric Manufacturing Co., Ltd., Tokyo 100-0004 (JP)
(72) Inventor: NAKAMURA, Hideyuki, Asaka City, Saitama 3518503 (JP); ABE, Sho, Asaka City, Saitama 3518503 (JP)
(74) Representative: Liesegang, Eva
(86) International application number: PCT/JP2023/021390
(87) International publication number: WO 2023/243537

(57) **Abstract**

A semiconductor device 1 according to the present invention includes a semiconductor base body 10, a first electrode 20, and an insulation layer 30. The semiconductor base body 10 includes: a first semiconductor region 12 of a first conductive type (n-type); a second semiconductor region 16 of a second conductive type (p type) formed at a position where the second semiconductor region 16 is in contact with the first electrode 2o and the insulation layer 30; and a third semiconductor region 18 of a first conductive type (n-type) formed in contact with the second semiconductor region 16 such that the third semiconductor region 18 surrounds the second semiconductor region 16 as viewed in a plan view. In the semiconductor device 1, assuming a total amount of dopants in the second semiconductor region 16 as S1 and a total amount of dopants in the third semiconductor region 18 as S2, a relationship of S1<S2 is satisfied, and a combination of the second semiconductor region 16 and the third semiconductor region 18 has a function of a Zener diode.
According to the semiconductor device 1 of the present invention, it is possible to increase breakdown strength compared to a conventional semiconductor device.

## Description

### Technical Field

The present invention relates to a semiconductor device.

### Background Art

Conventionally, to acquire a high withstand voltage, there has been known a semiconductor device on which a so-called guard ring is formed (see patent literature 1).

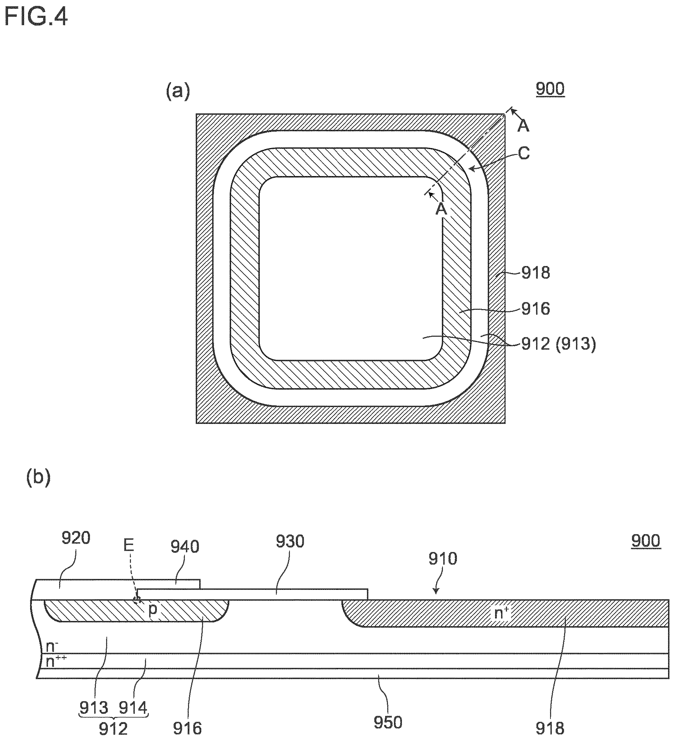

Fig. 4 is a view for describing a conventional semiconductor device 900. Fig. 4(a) is a plan view of the semiconductor device 900, and Fig. 4(b) is a cross-sectional view of the semiconductor device 900 taken along a line A-A in Fig. 4(a). Fig.4(b) may be also referred to as a cross-sectional view of a corner portion C of the semiconductor device 900. In Fig. 4(a), to indicate a shape of a first semiconductor region 912 and a shape of a guard ring 916 as viewed in a plan view, a first electrode 920, an insulation layer 930 and a field plate 940 disposed on a first main surface of a semiconductor base body 910 are not illustrated.

As illustrated in Fig. 4, the conventional semiconductor device 900 includes: the semiconductor base body 910, the first electrode 920 that is disposed on the first main surface of the semiconductor base body 910, the insulation layer 930 that is disposed on the first main surface so as to surround the first electrode 920 as viewed in a plan view, the field plate 940 that is connected to the first electrode 920 and is disposed on the insulation layer 930, and a second electrode 950 that is disposed on a second main surface of the semiconductor base body 910 on a side opposite to the first main surface. The semiconductor base body 910 has a first semiconductor region 912 of an n-type (an n⁻-type semiconductor region 913 and a n⁺⁺-type semiconductor region 914), and the guard ring 916 of a p-type, and a channel stopper 918 of an n⁺-type that is spaced apart from the guard ring 916 and is disposed on an outer edge side of the guard ring 916. In the conventional semiconductor device 900, in general, an outer edge of the corner portion C of the guard ring 916 has been formed in an arc shape as viewed in a plan view (see Fig. 4(a)).

### Citation List

### Patent Literature

Patent Literature 1: JP-A-05-75100

### Summary of Invention

### Technical Problem

In the conventional semiconductor device 900, there is a tendency that a contact edge E (a portion near a boundary between the first electrode 920 and the insulation layer 920 in the semiconductor base body 910) is liable to be broken when a reverse bias is applied to the semiconductor device thus giving rise to a drawback that it is difficult for the semiconductor device to increase its breakdown strength.

The present invention has been made so as to overcome the above-mentioned drawback, and it is an object of the present invention to provide a semiconductor device capable of increasing breakdown strength thereof compared to the conventional semiconductor device.

### [Solution to Problem]

A semiconductor device according to the present invention includes: a semiconductor base body; a first electrode disposed on a first main surface of the semiconductor base body; and an insulation layer disposed on the first main surface such that the insulation layer surrounds the first electrode as viewed in a plan view, wherein the semiconductor base body includes: a first semiconductor region of a first conductive type; a second semiconductor region of a second conductive type that is formed at a position where the second semiconductor region is in contact with the first electrode and the insulation layer; and a third semiconductor region of the first conductive type that is formed in contact with the second semiconductor region so as to surround the second semiconductor region as viewed in a plan view, and assuming a total amount of dopants in the second semiconductor region as S1 and a total amount of dopants in the third semiconductor region as S2, a relationship of S1<S2 is satisfied, and a combination of the second semiconductor region and the third semiconductor region has a function of a Zener diode.

### [Advantageous Effects of Invention]

According to the semiconductor device of the present invention, the semiconductor base body includes the third semiconductor region of the first conductive type that is formed in contact with the second semiconductor region so as to surround the second semiconductor region as viewed in a plan view, assuming the total amount of the dopants in the second semiconductor region as S1 and the total amount of dopants in the third semiconductor region as S2, the relationship of S1<S2 is satisfied, and the combination of the second semiconductor region and the third semiconductor region has a function of a Zener diode. Accordingly, when a reverse bias is applied to the semiconductor device, electric field strength between the second semiconductor region and the third semiconductor region becomes higher than electric field strength of a portion near a contact edge and hence, it is possible to generate an avalanche breakdown between the second semiconductor region and the third semiconductor region before the portion near the contact edge is broken. Accordingly, the semiconductor device according to the present invention becomes a semiconductor device capable of increasing breakdown strength compared to a conventional semiconductor device.

### Brief Description of Drawings

Fig. 1 is a view for describing a semiconductor device 1 according to an embodiment 1.
Fig. 2 is a view for describing a semiconductor device 2 according to an embodiment 2.
Fig. 3 is a view for describing the manner of extending of a depletion layer at a corner portion of a semiconductor device.
Fig. 4 is a view for describing a conventional semiconductor device 900.

### [Description of embodiments]

Hereinafter, a semiconductor device according to the present invention is described based on respective embodiments illustrated in drawings. The respective embodiments described hereinafter are not intended to limit the present invention according to claims.

Further, it is not always the case that the constitutional elements described in the embodiments and all combinations of these constitutional elements are indispensable for the solutions to solve the problems of the present invention.

### [Embodiment 1]

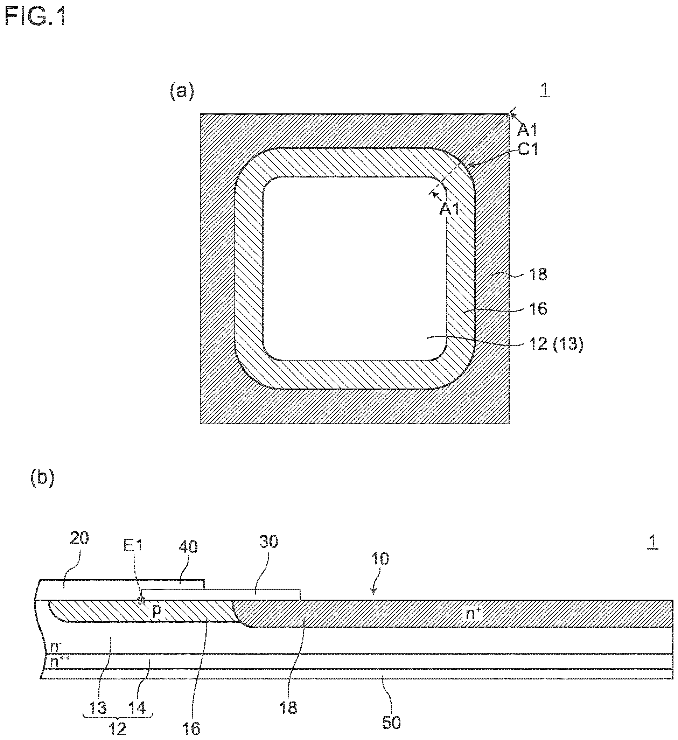

Fig. 1 is a view for describing a semiconductor device 1 according to an embodiment 1. Fig. 1(a) is a plan view of the semiconductor device 1 and Fig. 1(b) is a cross-sectional view of the semiconductor device 1 taken along a line A1-A1 in Fig. 1(a). Fig. 1(b) may be also referred to as a cross-sectional view of a corner portion C1 in the semiconductor device 1. In Fig. 1(a), to illustrate the shapes of a first semiconductor region 12, a second semiconductor region 16 and a third semiconductor region 18 as viewed in a plan view, a first electrode 20, an insulation layer 30 and a field plate 40 that are disposed on a first main surface of a semiconductor base body 10 are not illustrated.

As illustrated in Fig. 1, the semiconductor device 1 according to the embodiment 1 includes: the semiconductor base body 10; the first electrode 20 that is disposed on the first main surface of the semiconductor base body 10; the insulation layer 30 that is disposed on the first main surface so as to surround the first electrode 20 as viewed in a plan view; the field plate 40 that is connected to the first electrode 20 and is disposed above the insulation layer 30; and a second electrode 50 that is disposed on a second main surface of the semiconductor base body 10 on a side opposite to the first main surface of the semiconductor base body 10. The semiconductor device 1 illustrated in Fig. 1 may further include constitutional elements besides the above-mentioned constitutional elements. The semiconductor device 1 is a Schottky barrier diode.

The semiconductor base body 10 includes: a first semiconductor region 12 of a first conductive type (n-type in the embodiment 1); a second semiconductor region 16 of a second conductive type (p-type in the embodiment 1) and a third semiconductor region 18 of the first conductive type (n-type in the embodiment 1). The concentration of dopants in the third semiconductor region 18 is higher than the concentration of dopants in an n⁻-type semiconductor region 13 and lower than the concentration of dopants in an n⁺⁺ -type semiconductor region 14 described later. Accordingly, in Fig. 1, "n⁺" is indicated in the third semiconductor region 18. In the semiconductor device 1, the second semiconductor region 16 may be also referred to as a guard ring, and the third semiconductor region 18 may be also referred to as a channel stopper.

The first semiconductor region 12 includes an n⁻-type semiconductor region 13 disposed on a first main surface side, and an n⁺⁺-type semiconductor region 14 disposed on a second main surface side. The wafer resistivity of the n⁻-type semiconductor region 13 can be set to 0.6 to 25 Ωcm, for example. Further, a thickness of the n⁻-type semiconductor region 13 can be set to 4 to 65 µm, for example. The concentration of dopants on the surface of an n⁺⁺-type semiconductor region 14 can be set to 1×10²⁰ m⁻³ or more, for example. Further, a thickness of the n⁺⁺-type semiconductor region 14 is set to 100 to 400 µm, for example.

The second semiconductor region 16 is formed at the position where the first electrode 20 and the insulation layer 30 are in contact with each other. In the semiconductor device 1, as viewed in a plan view, an outer edge of the corner portion C1 of the second semiconductor region 16 (indicated by a symbol only with respect to the corner portion C1 disposed on a right upper portion of a surface of a sheet on which Fig. 1(a) is drawn) is formed in an arc shape. A total amount of dopants in the second semiconductor region 16 can be set to 3×10¹² to 8×10¹² cm⁻², for example. Further, a depth of the second semiconductor region 16 can be set 0.4 to 4.0 µm, for example.

In this specification, "a total amount of dopants" means a value obtained by integrating the concentration distribution of dopants in a depth direction from the surface. Although the total amount of dopants is a value relating to a dose amount (a doped amount of dopants), there may be a case where it is not always possible to acquire a proper correlation between a withstand voltage and a dose amount. This is because an amount of dopants is changeable depending on heat treatment or the like.

The third semiconductor region 18 is formed in contact with the second semiconductor region 16 such that the third semiconductor region 18 surrounds the second semiconductor region 16 as viewed in a plan view. The third semiconductor region 18 is formed such that the third semiconductor region 18 extends to an end portion of the semiconductor device 1 as viewed in a plan view. Further, the third semiconductor region 18 is formed to a depth deeper than the deepest portion of the second semiconductor region 16 from the first main surface. A total amount of dopants in the third semiconductor region 18 may be set to 3×10¹² to 1×10¹⁵ cm⁻², for example. The depth of the third semiconductor region 18 can be set to 0.5 to 5.0 µm, for example.

In the semiconductor device 1, assuming the total amount of dopants in the second semiconductor region 16 as S1 and the total amount of dopants in the third semiconductor region 18 as S2, the relationship of S1 < S2 is satisfied. In the semiconductor device 1, it is preferable that the relationship of 0.15 < (S1/S2) < 1 be satisfied. In the semiconductor device 1, the combination of the second semiconductor region 16 and the third semiconductor region 18 has a function of a Zener diode.

In this specification, "Zener diode" includes not only a Zener diode where Zener breakdown occurs on a p-n junction surface but also a Zener diode where an avalanche breakdown occurs depending on a condition.

Hereinafter, advantageous effects acquired by the semiconductor device 1 according to the embodiment 1 are described.

According to the semiconductor device 1 of the embodiment 1, the semiconductor base body 10 includes: the first semiconductor region 12 of a first conductive type; the second semiconductor region 16 of a second conductive type formed at the position where the first electrode 20 and the insulation layer 30 are in contact with each other; and the third semiconductor region 18 of the first conductive type formed in contact with the second semiconductor region 16 such that the third semiconductor region 18 surrounds the second semiconductor region 16 as viewed in a plan view, and assuming the total amount of dopants in the second semiconductor region 16 as S1 and the total amount of dopants in the third semiconductor region 18 as S2, the relationship of S1 < S2 is satisfied, and the combination of the second semiconductor region 16 and the third semiconductor region 18 has a function of a Zener diode. Accordingly, when a reverse bias is applied to the semiconductor device 1, it is possible to increase electric field strength between the second semiconductor region 16 and the third semiconductor region 18 than electric field strength near a contact edge E1 and hence, it is possible to generate avalanche breakdown between the second semiconductor region 16 and the third semiconductor region 18 before the contact edge E1 is broken. As a result, the semiconductor device 1 according to the embodiment 1 becomes a semiconductor device having higher breakdown strength than a conventional semiconductor device.

Further, according to the semiconductor device 1 of the embodiment 1, the third semiconductor region 18 is formed to a depth deeper than the deepest portion of the second semiconductor region 16 from the first main surface and hence, it is possible to ensure a sufficient contact between the second semiconductor region 16 and the third semiconductor region 18.

Further, according to the semiconductor device 1 of the embodiment 1, the relationship of 0.15 < (S1/S2) < 1 is satisfied. Accordingly, a ratio of the total amount of dopants S1 in the second semiconductor region 16 with respect to the total amount of dopants S2 in the third semiconductor region 18 can be increased to some extent and hence, it is possible to suppress lowering of a withstand voltage attributed to an excessively small amount of dopants in the second semiconductor region 16.

Further, the semiconductor device 1 of the embodiment 1 forms a Schottky barrier diode that can increase breakdown strength compared to the prior art.

### [Embodiment 2]

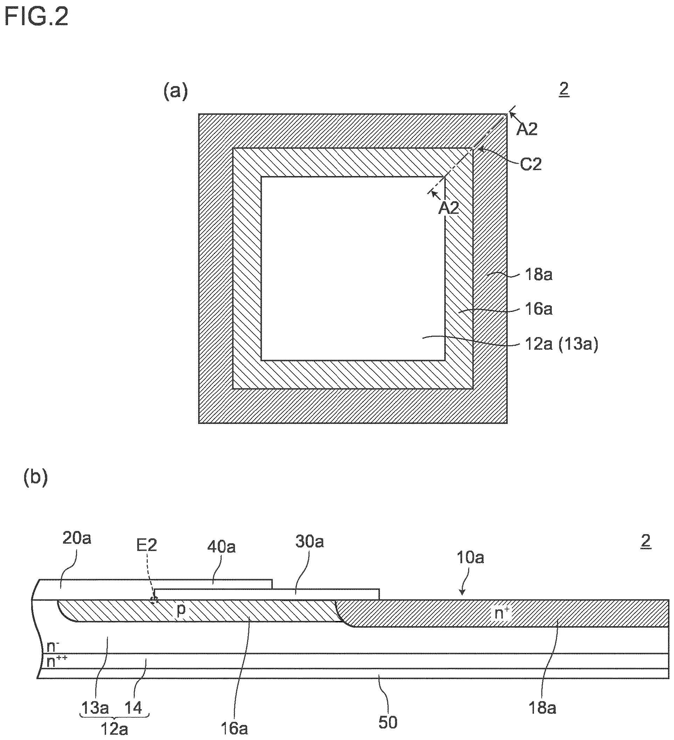

Fig. 2 is a view for describing a semiconductor device 2 according to an embodiment 2. Fig. 2(a) is a plan view of the semiconductor device 2, and Fig. 2(b) is a cross-sectional view of the semiconductor device 2 taken along a line A2-A2 in Fig. 2(a). Fig. 2(b) may be also referred to as a cross-sectional view of a corner portion C2 in the semiconductor device 2. Also in Fig. 2(a), to display shapes of a first semiconductor region 12a, a second semiconductor region 16a and a third semiconductor region 18a as viewed in a plan view, a first electrode 20a, an insulation layer 30a and a field plate 40a disposed on a first main surface of a semiconductor base body 10a are not illustrated.

The semiconductor device 2 according to the embodiment 2 has basically substantially the same configuration as the semiconductor device 1 according to the embodiment 1. However, the semiconductor device 2 according to the embodiment 2 differs from the semiconductor device 1 according to the embodiment 1 with respect to the shape of an outer edge of the second semiconductor region as viewed in a plan view. In the semiconductor device 2 according to the embodiment 2, as viewed in a plan view, the outer edge of the second semiconductor region 16a is formed in a rectangular shape (a square shape). That is, as viewed in a plan view, an outer edge of a corner portion C2 of the second semiconductor region 16a has an angular shape.

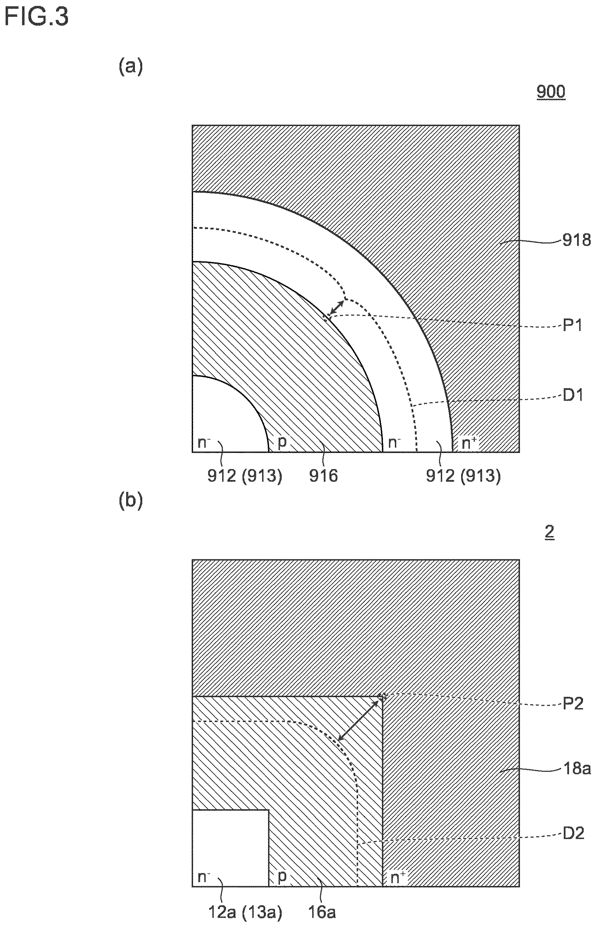

In this embodiment 2, a phenomenon obtained by forming the outer edge of the second semiconductor region 16a in a rectangular shape is described with reference to Fig. 3. Fig. 3 is a view for describing the manner of extending a depletion layer at a corner portion of a semiconductor device. Fig. 3(a) is a plan view illustrating a corner portion C of the conventional semiconductor device 900, and Fig. 3(b) is a plan view illustrating the corner portion C2 of the semiconductor device 2 according to the embodiment 2. In the same manner as the cases described in Fig. 2(a) and Fig. 4(a), also in Fig. 3, a first electrode, an insulation layer and a field plate disposed on a first main surface of a semiconductor base body are not illustrated.

First, in the conventional semiconductor device 900, as illustrated in Fig. 3(a), as viewed in a plan view, an outer edge of a corner portion C of the guard ring 916 is formed in an arc shape. Further, the outer edge of the guard ring 916 is disposed in contact with the n⁻-type semiconductor region 913 having lower concentration of dopants than the guard ring 916. Accordingly, when a reverse bias is applied to the semiconductor device 900, a depletion layer is liable to extend from an outer edge boundary of the guard ring 916 to an n⁻-type semiconductor region 913 side (outer side) (see a broken line D₁ in Fig. 3(a)). At this stage of the operation, in view of a charge balance, spreading of the depletion layer is liable to become narrow at a point that corresponds to 45° of an arc (see point P₁ in Fig. 3(a)) (see double-headed arrow in Fig. 3(a)). Accordingly, in the conventional semiconductor device 900, electric field strength is liable to be concentrated near such a point.

On the other hand, in the semiconductor device 2 according to the embodiment 2, as illustrated in Fig.3 (b), as viewed in a plan view, an outer edge of the second semiconductor region 16a (guard ring) has a rectangular shape. Further, the outer edge of the second semiconductor region 16a is in contact with a third semiconductor region 18a having a larger total amount of dopants than the second semiconductor region 16a (usually, the concentration of dopants being also high). With such a configuration, when a reverse bias is applied, the depletion layer easily extends from an outer edge boundary of the second semiconductor region 16a toward a second semiconductor region 16a side (an inner side) (see a broken line D2 in Fig. 3 (b)). With such a shallow junction, in view of the relationship of a charge balance of an interface, spreading of the depletion layer is accelerated in a vertex (a portion corresponding to 45°, a point P2 in Fig. 3(b)) of the second semiconductor region 16a (see double-headed arrow in Fig. 3(b)). Accordingly, in the semiconductor device 2 of the embodiment 2, electric field strength can be alleviated near such a point.

In the semiconductor device 1 according to the embodiment 1, the outer edge of the corner portion C1 of the second semiconductor region 16 has an arc shape. However, different from the case of the conventional semiconductor device 900, the outer edge of the second semiconductor region 16 is in contact with the third second semiconductor region 18 having a larger total amount of dopants than the second semiconductor region 16a. In this case, the depletion layer easily extends from an outer edge boundary of the second semiconductor region 16 toward a second semiconductor region 16 side (an inner side) and hence, different from the case of the conventional semiconductor device 900, spreading of the depletion layer is not obstructed even at a point that corresponds to 45° of the arc.

In the semiconductor device 2, an outer edge (a boundary between n⁻-type semiconductor region 13a and the second semiconductor region 16a) of the first semiconductor region 12a (n⁻-type semiconductor region 13a) is formed in a rectangular shape. Further, the outer edge of the second semiconductor region 16a is a boundary between the second semiconductor region 16a and the third semiconductor region 18a and hence, an inner edge of the third semiconductor region 18a is also formed in a shape that corresponds to the second semiconductor region 16a. Although the illustration as view in a plan view is omitted, the first electrode 20a, the insulation layer 30a, and the field plate 40a that are disposed on the first main surface are also formed in a shape that corresponds to the second semiconductor region 16a (the shape where the outer edge is formed in a rectangular shape as view in a plan view).

The semiconductor device 2 according to the embodiment 2 differs from the semiconductor device 1 according to the embodiment 1 with respect to the shape of the outer edge of the second semiconductor region as viewed in a plan view. However, according to the semiconductor device 2, the semiconductor base body 10a has: the first semiconductor region 12a of a first conductive type; the second semiconductor region 16a of a second conductive type formed at the position where the first electrode 20a and the insulation layer 30a are in contact with each other; and a third semiconductor region 18a of a first conductive type formed in contact with the second semiconductor region 16a such that the third semiconductor region 18a surrounds the second semiconductor region 16a as viewed in a plan view, and assuming a total amount of dopants in the second semiconductor region 16a as S1 and a total amount of dopants in the third semiconductor region 18a as S2, the relationship of S1<S2 is satisfied and hence, the combination of the second semiconductor region 16a and the third semiconductor region 18a has a function of a Zener diode. Accordingly, when a reverse bias is applied, electric field strength between the second semiconductor region 16a and the third semiconductor region 18a becomes larger than a field strength near a contact edge E2 and hence, it is possible to generate an avalanche breakdown between the second semiconductor region 16a and the third semiconductor region 18a before the contact edge E2 is broken. As a result, the semiconductor device 2 according to the embodiment 2 becomes a semiconductor device capable of having higher breakdown strength than the conventional semiconductor device in the same manner as the semiconductor device 1 according to the embodiment 1.

Further, according to the semiconductor device 2 of the embodiment 2, as viewed in a plan view, an outer edge of the second semiconductor region 16a is formed in a rectangular shape (square shape). Accordingly, when a reverse bias is applied, a depletion layer easily extends from the corner portion of the second semiconductor region 16a and hence, a field strength at a vertex (a portion that corresponds to 45°) of the second semiconductor region 16a can be alleviated. As a result, in the semiconductor device 2 according to the embodiment 2, it is possible to generate an avalanche breakdown at a peripheral portion more easily than the corner portion C2 of the outer edge of the second semiconductor region 16a and hence, breakdown strength can be further increased.

The semiconductor device 2 according to the embodiment 2 also acquires, in addition to the above-mentioned advantageous effects, the advantageous effects that the semiconductor device 1 according to the embodiment 1 possesses.

Although the present invention has been described based on the above-mentioned respective embodiments, the present invention is not limited to the above-mentioned respective embodiments. The present invention can be carried out in various modes without departing from the gist of the present invention. For example, the following modifications are conceivable.

(1) The positions, the sizes and the like described in the above-mentioned respective embodiments (also including the respective modifications described hereinafter) are provided for an exemplifying purpose, and can be changed provided that the advantageous effects of the present invention are not impaired.
(2) In the above-mentioned respective embodiments, the semiconductor devices 1, 2 are formed of a Schottky barrier diode. However, the semiconductor device according to the present invention is not limited to a Schottky barrier diode. The present invention is also applicable to diodes other than a Schottky barrier diode, transistors and thyristors. Further, in the above-mentioned respective embodiments, the n-type is set as the first conductive type and the p type is set as the second conductive type. However, depending on a kind of the semiconductor device, the p type is set as the first conductive type, and the n-type is set as the second conductive type.
(3) In the semiconductor device 2 according to the above-mentioned embodiment 2, as viewed in a plan view, the outer edge of the second semiconductor region 16a is formed in a square shape. However, the present invention is not limited to such a configuration. The outer edge of the second semiconductor region may be formed in a rectangular shape.

### Reference Signs List

1, 2: semiconductor device
10, 10a: semiconductor base body
12, 12a: first semiconductor region
13, 13a: n⁻-semiconductor region
14: n⁺-semiconductor region
16, 16a: second semiconductor region
18, 18a: third semiconductor region
20, 20a: first electrode
30, 30a: insulation layer
40, 40a: field plate
50: second electrode
C1, C2: corner portions
E1, E2: contact edge

## Claims

1. A semiconductor device comprising:
a semiconductor base body;
a first electrode disposed on a first main surface of the semiconductor base body; and
an insulation layer disposed on the first main surface such that the insulation layer surrounds the first electrode as viewed in a plan view, wherein
the semiconductor base body includes: a first semiconductor region of a first conductive type; a second semiconductor region of a second conductive type that is formed at a position where the second semiconductor region is in contact with the first electrode and the insulation layer; and a third semiconductor region of the first conductive type that is formed in contact with the second semiconductor region so as to surround the second semiconductor region as viewed in a plan view, and
assuming a total amount of dopants in the second semiconductor region as S1 and a total amount of dopants in the third semiconductor region as S2, a relationship of S1<S2 is satisfied, and
a combination of the second semiconductor region and the third semiconductor region has a function of a Zener diode.

2. The semiconductor device according to claim 1, wherein the third semiconductor region is formed to a depth deeper than a deepest portion of the second semiconductor region from the first main surface.

3. The semiconductor device according to claim 1, wherein a relationship of 0.15<(S1/S2)<1 is satisfied.

4. The semiconductor device according to claim 1, wherein an outer edge of the second semiconductor region is formed in a rectangular shape as viewed in a plan view.

5. The semiconductor device according to claim 1, wherein the semiconductor device is a Schottky barrier diode.
